# EUROPEAN PATENT SPECIFICATION

(11) **EP 1 396 050 B1**
(45) Date of publication and mention of the grant of the patent: **29.09.2010**
(21) Application number: 02753337.1
(22) Date of filing: 06.06.2002
(51) Int. Cl.: H01R 4/58

(54) **INTERCONNECTION COMPONENT INCLUDING A PRE-STRESSED ANISOTROPIC CONDUCTIVE ELASTOMER**
STECKERKOMPONENTE MIT VORBELASTETEN ANISOTROPEN LEITFÄHIGEN ELASTOMERMATERIALIEN
COMPOSANT D'INTERCONNECTION CONTENANT UN ELASTOMERES CONDUCTEURS ANISOTROPES PRECONTRAINT

(30) Priority: 14.06.2001 US 298163 P; 08.08.2001 US 311178 P; 03.10.2001 US 970072; 08.01.2002 US 346820 P; 09.01.2002 US 347114 P
(43) Date of publication of application: 10.03.2004
(73) Proprietor: Paricon Technologies Corporation, Fall River, MA 02720 (US)
(72) Inventor: WEISS, Roger, E., Foxboro, MA 02035 (US); CORNELl, Christopher, S. Dartmouth, MA 02748 (US); MCCARTHY, Matthew, Taunton, MA 02780 (US); SIMONS, Everett, Mansfield, MA 02048 (US)
(74) Representative: Jones, Graham Henry
(86) International application number: PCT/US2002/018059
(87) International publication number: WO 2002/103848

(56) References cited:
- EP-A2- 0 420 690
- US-A- 4 209 481
- US-A- 4 292 261
- US-A- 4 778 635
- US-A- 4 820 376
- US-A- 5 132 058
- US-A- 5 745 346
- US-A- 5 745 346
- US-B1- 6 168 442
- US-B1- 6 168 442

## Description

### FIELD OF THE INVENTION

This invention relates to the field of electrical interconnects made with anisotropic conductive elastomer material.

### BACKGROUND OF THE INVENTION

Anisotropic Conductive Elastomer (ACE) is a composite of conductive elements (e.g., metal particles or fine wires) in an elastomeric matrix that is constructed such that it conducts along one axis only. In general, this type of material is made to conduct through its thickness. ACE may be produced by mixing magnetic particles or other conductors with a liquid resin, forming the mix into a continuous sheet, and curing the sheet in the presence of a magnetic field. This results in the conductors forming columns through the sheet thickness. These columns are electrically conductive, creating anisotropic conductivity. The sheet has the unique property of being both flexible and anisotropically conductive. The sheets are subsequently cut to the desired shape and attached to a frame or connector structure by mechanical means, or by the application of adhesive. In some cases, the cut ACE is simply placed inside the interconnect structure. These methods of ACE use result in material waste, require assembly labor, and can provide less than optimum performance.

In a typical application of ACE, the interconnect formed using the ACE replaces the soldered interconnect to allow a separable interconnection. Separable interconnection is generally required for testing the device, conditioning the device (burn-in) and for final application in the OEM product. One such example is in a Land Grid Array (LGA) where an array of pads on a device needs to be connected to a matching array on a board. A second example is when a Ball Grid Array (BGA), consisting of a device with an array of solder balls, is to be separably connected to a matching array on the board. In both of these examples, a layer of ACE material placed between the device and the board can, when properly used, provide a reliable connection.

Moreover, the behavior of the elastomeric material is critical to the success of the interconnect's performance. Typical highly filled elastomeric materials exhibit poor elastic properties, and when formed into discrete button-like contacts, tend to move like putty, taking a severe set. These materials exhibit little residual spring force. These factors impact on the reliability of the contact, and virtually preclude multiple device insertions with different devices. Because these highly filled materials have poor elastic properties, an external spring member is required to create a contact force. However, the elastomeric button flows continuously under the force. The conventional solution is to limit the flow with a stop. The net effect is a very low contact force. In addition, elastomers in sheet form can have excellent elastic properties, but tend to behave like incompressible fluids. This behavior demands that the connector system design using sheet elastomers provide for a place for the material to move.

An illustrative example of the use of ACE is in the prior art assembly method for a surface mounted LGA or BGA connector. The connector consists of an alignment frame and a piece of ACE material. The ACE may be attached to the alignment frame either by mechanical means or by an adhesive. In some applications the ACE can be placed loosely on a printed circuit board, and compressed in place between the device and the board. This may be acceptable in applications such as bum-in and test, but not for most OEM applications.

It is important for the surface of the solder ball, pad or pin that touches the circuit pads be as free of defects as possible. Deformation of the solder ball of a BGA, especially in the apex area, can result in a poor or a non-fimctioning soldered connection. The BGA device is typically tested using a custom socket assembly that utilizes spring-loaded contacts. In one type of test device, these contacts comprise a pin with a serrated face that allows tangential contact with individual solder balls.

Although the contact face provides an excellent electrical contact, the overall length of the pin creates a higher electrical inductance for the contact pin assembly as compared to the short path length provided by the ACE used in the invention. As microprocessor speeds increase, inductance hampers performance. Some manufacturers have seen this degradation at bandwidths as low as 500 MHz.

When a layer of ACE made from magnetically aligned particles is compressed between two electrical conductors, the particles in the compressed column come into contact with each other and the conductors, forming an electrically conductive path. As devices using ACE warm up, the elastomeric material thermally expands at a higher rate than the metal, ceramic and other components of the system. The lateral expansion of the elastomer disrupts the particle column integrity, and the vertical expansion tends to unload the columns, which expand at a much lower rate. Both of these effects impact on the electrical stability of the interconnect with temperature.

U.S. Patent No. 4,292,261 to Teizo Kotani, et al., discloses a pressure sensitive conductor comprising electrically conductive magnetic particles dispersed in an insulating elastomer, and a method of making such a pressure sensitive conductor. U.S. Patent No. 5,745,347 to Nobuyoshi Ogawa, et al., discloses a connecting socket for a semiconductor package suitable for establishing an electrical connection between an electronic circuit board and a surface-mountable semiconductor package.

### SUMMARY OF THE INVENTION

It is therefore an object of this invention to provide an interconnection component with an integral ACE.

It is a further object of this invention to provide such a component that minimizes ACE material waste.

It is a further object of this invention to provide such a component that requires less assembly labor.

It is a further object of this invention to provide such a component that enhances the interconnected performance of the ACE.

It is a further object of this invention to provide a device for interconnecting two or more components, which is capable of accommodating repeated thermal excursions when in use.

It is a further object of this invention to provide a device for interconnecting two or more components using a compressive load, which reduces the distortion of electrical pathways during the assembly process by pre-tensioning the interconnect medium in the plane that it would have been partially extruded into by the application of the compressive load.

It is a further object of this invention to provide a device for interconnecting two or more components, which resists the distortion from thermal or mechanical changes perpendicular to electrically conductive pathways within an anisotropically conductive medium, by constraining the perimeter of the anisotropically conductive medium.

It is a further object of this invention to provide, in a device for interconnecting two or more components, mechanical features to align the components.

It is a further object of this invention to provide a device for interconnecting two or more components, which is capable of repeated use for testing, conditioning and final application of the components.

It is a further object of this invention to provide a device for interconnecting two or more components, which provides flow space into which the elastomer materials in the device may flow under compression.

It has been shown that the electrical instability caused by the differential thermal expansion of the elastomer can be eliminated by pre-stressing (stretching) the sheet to a level beyond that provided by the expansion of the elastomer over the operational thermal range. As a stretched sheet of elastomer is heated, it will relax with temperature but not physically move laterally until all the stress is gone. Hence no disruptive motion of the columns will occur over the system thermal operating range when sufficient stretch has been applied. Furthermore, as the sheet is stretched, the height of the columns does not change but rather the elastomer between the columns necks down to provide the material for the increased area of the stretched sheet. This necking provides the additional free volume needed by the system to offset the vertical expansion of the elastomer with temperature in a direction parallel to the columns.

Specifically, in one embodiment of the invention, the sheet of ACE is uniformly stretched and mounted to a rigid frame. The sheet is held in tension by the frame. The presence of the tension is demonstrated, among other ways, by the resonant tone given off by the stretched elastomer when the frame is struck - much like a tambourine, drum or other percussion style musical instrument.

An added advantage of stretching the ACE and securing it to a frame prior to its being compressed between devices is the reduction in lateral distortion during the assembly process. With typical systems, as the ACE sheet is compressed, it is slightly extruded laterally, causing the columns towards the perimeter to bow. Since the top and bottom of the ACE sheet are constrained by friction, the middle of the sheet moves laterally more than the surfaces, causing initially vertical columns to bow. If the lateral motion of the ACE is constrained during the assembly process, this bowing is prevented.

This invention features in one embodiment an interconnection component with integral conductive elastomeric sheet material, comprising a connector frame, and an anisotropic conductive elastomer (ACE) integrally coupled to the connector frame. The integral coupling may be enhanced with one or more openings in the frame, in which the ACE is held. The frame may be annular, and the openings along at least two opposed sides of the frame. The frame may be generally rectangular and the openings along all four sides of the frame.

The interconnection component may further comprise one or more protrusions in the ACE, and in contact with the frame, to help to maintain registration between the interconnection component and the connected device. The ACE may be in tension in the frame. The conductive columns in the ACE may protrude from at least one surface of the ACE. The ACE may define one or more depressions proximate at least some of the conductive columns. The interconnection component may further comprise one or more spacer members between one or more portions of the frame, and the ACE.

The interconnection component may further comprise a flex circuit interconnect in electrical contact with the ACE, to enhance interconnection of a device to the ACE. The interconnection component may still further comprise a series of electrical interconnects on the ACE surface and in electrical contact with the conductive columns.

The interconnection component of the present invention may be formed by providing a connector frame, casting uncured ACE material onto the connector frame, and curing the ACE, to integrally couple the ACE to the connector frame.

The method of forming the interconnection component of the present invention may further comprise providing a casting plate defining an annular cavity with a central pedestal, and placing the frame into the cavity before casting the uncured ACE. The method may still further comprise providing one or more openings in the frame, in which the ACE is held. The conductive columns in the ACE may protrude from at least one surface of the ACE. The protrusion may be created with a material that is liquid at the ACE casting temperature, and placed between the pedestal and the uncured ACE.

The method may still further comprise providing an array of high permeability zones in the central pedestal to focus the magnetic field such that the columns of particles are preferentially positioned in the area of the electrical interconnection.

Also described herein is a method of forming an interconnection component with conductive elastomeric sheet material, comprising providing a frame defining an opening, placing an anisotropic conductive elastomer (ACE) material in tension, and, while the ACE is in tension, coupling the ACE to the frame, with the ACE spanning the opening. In this method, the placing step may comprise stretching the ACE. Stretching the ACE may comprise providing a generally uniform radial tension in the ACE. The placing step may comprise providing a mounting frame that holds the ACE in tension. The mounting frame may comprise a series of mechanical structures that hold the ACE at a plurality of separate locations. The placing step may comprise providing a variable stretch frame assembly that provides a variable stretch to the ACE.

### BRIEF DESCRIPTION OF THE DRAWINGS

Other objects, features and advantages will occur to those skilled in the art from the following description of the preferred embodiments of the invention, and the accompanying drawings, in which:
FIG. 1 is a partial cross-sectional view of one embodiment of an elastomeric sheet conductor ACE of this invention, with the sheet under lateral tension, causing a vertical contraction of the elastomeric matrix relative to the heights of the electrically conductive columns;
FIG. 2A is a top view of one embodiment of an ACE sheet for this invention that is to be stretched on a frame;
FIG. 2B shows the same sheet with stress relief slots;
FIG. 3 shows a device used to stretch the ACE sheet;
Figure 4A is a perspective view of an ACE casting plate;
Figure 4B shows an alignment frame placed in the casting plate of Figure 4A;
Figure 4C schematically depicts uncured ACE material being spread over the assembly of Figure 4B;
Figure 5A depicts an alternative alignment frame in place in a casting plate, with Figure 5B showing in enlarged detail a portion of that frame;
Figure 5C depicts the frame of Figure 5A with the cast, cured ACE material thereon;
Figure 6A depicts an alternative version of the central pedestal for the casting plate, with Figure 6B showing in enlarged detail a portion of that casting plate;
Figure 7 depicts the use of spacer structures on the frame, before the ACE is cast;
Figures 8A through 8D depict another alternative for the invention, in which a flexible circuit is used in the assembly;
Fig. 9 is a cross-sectional view of a BGA package interconnected to the ACE of the invention using a flexible circuit interconnect;
Fig. 10 is an enlarged sectional view of a single ball of the package of Fig. 9;
Figure 11A depicts an alternative to the flexible circuit of Figures 8-10, wherein contacts are directly plated on the ACE, with Figure 11B showing in enlarged detail a portion of the plated ACE surface;
Figure 12A depicts another alternative for the central pedestal of the casting plate for the invention, in which an array of zones of high magnetic permeability material are used, with Figure 12B showing in enlarged detail a portion of the array of Figure 12A;
Figure 13 is a top view of a fixed stretch frame ACE coupon;
Figure 14 shows a stretch frame for the coupon of Figure 13;
Figure 15 shows an assembly of the coupon of Figure 13 mounted on the frame of Figure 14 and with a rigid alignment frame attached to the coupon;
Figure 16 is an exploded view of an assembly using the pre-stressed ACE in the alignment frame from Figure 15;
Figure 17 is a top view of a frame for applying a variable but uniform pre-stress to an ACE coupon;
Figure 18 is a side, schematic view of the frame of Figure 17 loaded with an ACE coupon; and
Figure 19 is a view of the assembly of Figure 15 in use to uniformly stretch the ACE coupon.

### DETAILED DESCRIPTION OF THE PREFERRED EMBODIMENTS

The elastomeric device of the invention, for electrically interconnecting two or more components, generally includes the following basic elements: an elastomeric matrix having one or more outer surfaces; one or more electrically conductive pathways through the matrix; and a frame that holds the matrix in tension perpendicular to the electrically conductive pathways.

### Bulk Properties of Elastomer

Materials with pathways of aligned conductors in an elastomeric matrix (ACE), use less metal than elastomer (by volume), and the material's in-plane properties tend to take on the elastic behavior of the base elastomer. However, as noted above, the behavior of the elastomeric material is critical to the success of the device's performance. Previously used materials, such as highly filled materials, typically exhibit little residual spring force, which reduces the reliability of the contact and virtually precludes multiple device insertions with different devices. In the present invention, these drawbacks are overcome by using a matrix comprised of elastomers which exhibit nearly perfect elasticity over a broad temperature range. Specifically, a 1:1 mixture of GE-615 and GE-630 silicone (General Electric Corp.) has been identified as having close to ideal behavior. In a preferred embodiment, the matrix is formed from a blend of from 2% to 25% by volume of magnetically aligned particles in a base of GE-615 plus GE-630 or equivalent (by equivalent is meant an elastomeric material that retains most of its modulus of compression over a temperature range of 20° C to 70° C.) This combination will not take a set over a wide temperature range.

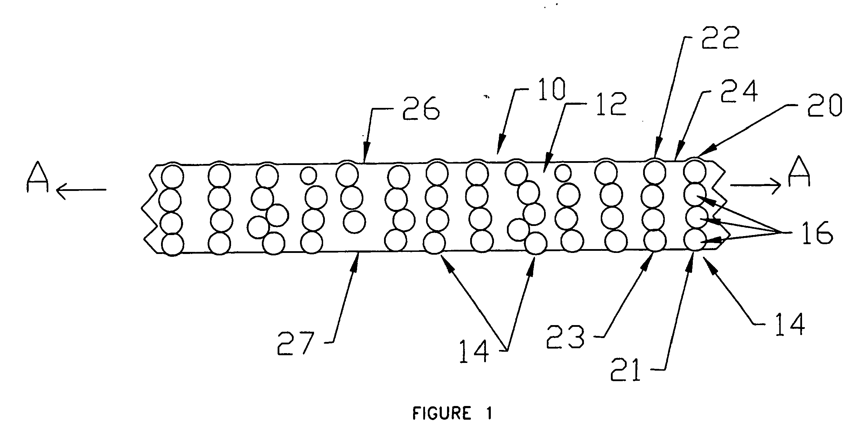

Generally, in one embodiment, to carry out the method of making an elastomeric device for electrically interconnecting two or more components, a plurality of conductive, magnetic particles 16, FIG. 1, are embedded in an elastomer 12 which preferably retains-most of its modulus of compression over a temperature range of between about 20° C to 70° C, by mixing the particles in the elastomer before the elastomer sets and applying a magnetic force to the particles so that the particles align themselves in electrically isolated columns 14 as the elastomer sets. This forms an elastomeric matrix having one or more outer surfaces 26, 27 and comprising one or more electrically conductive pathways 14 through the matrix. The matrix is placed in tension in the direction perpendicular to the electrically conductive pathways (in the direction of arrows A). The matrix can be tensioned by a casting methodology, or stretched mechanically, or thermally expanded. The tension causes the ends of columns 14 to bulge out of the surface, as shown schematically at areas 20-23. The areas 24 between the column ends are located below the column ends themselves, creating voids into which the elastomer can expand as it is heated. The material is bonded to a frame. This maintains the tension. Alternatively, the material may be held in tension (without being bonded to a frame) until it is assembled; the assembly in this case maintains the matrix in tension. The matrix is then compressed between the components to be electrically interconnected.

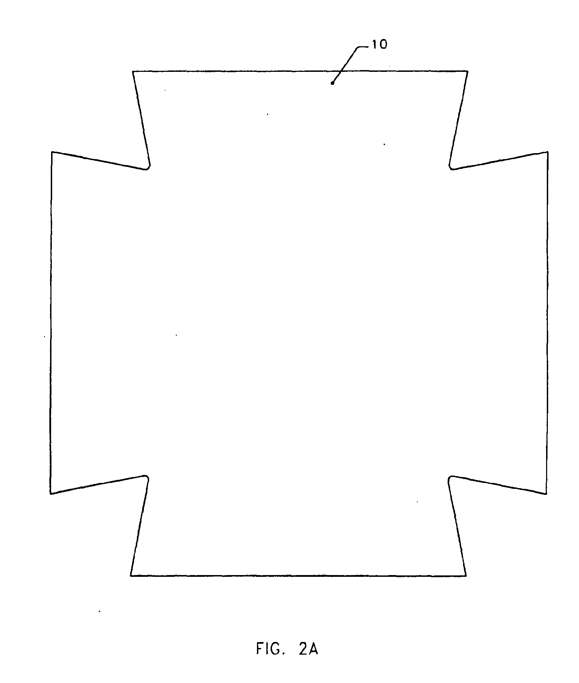

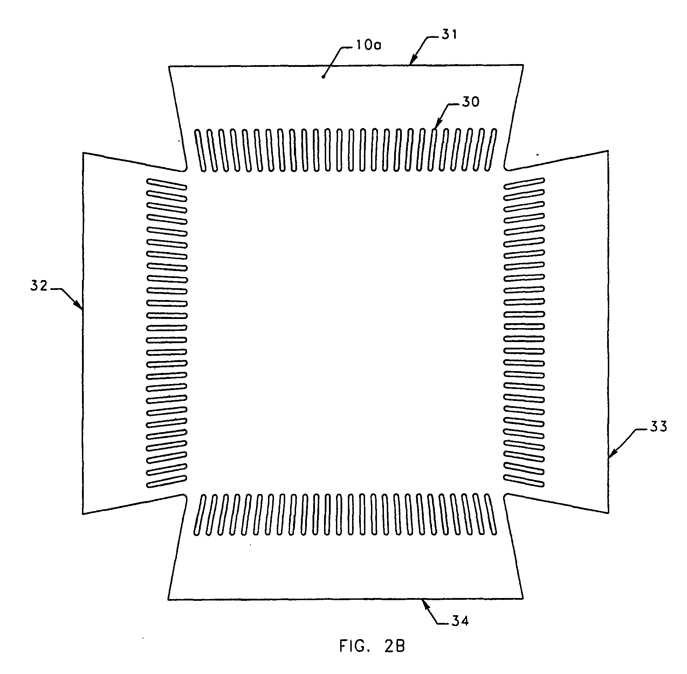

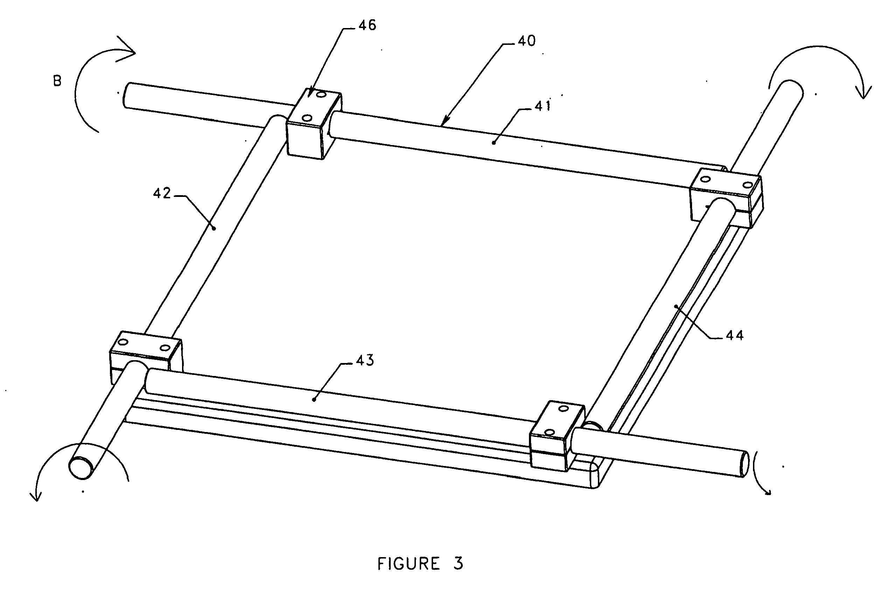

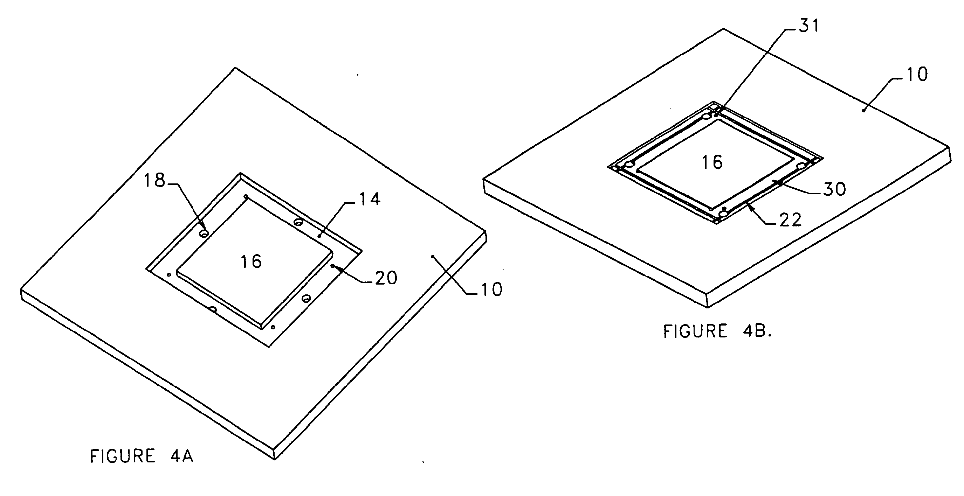

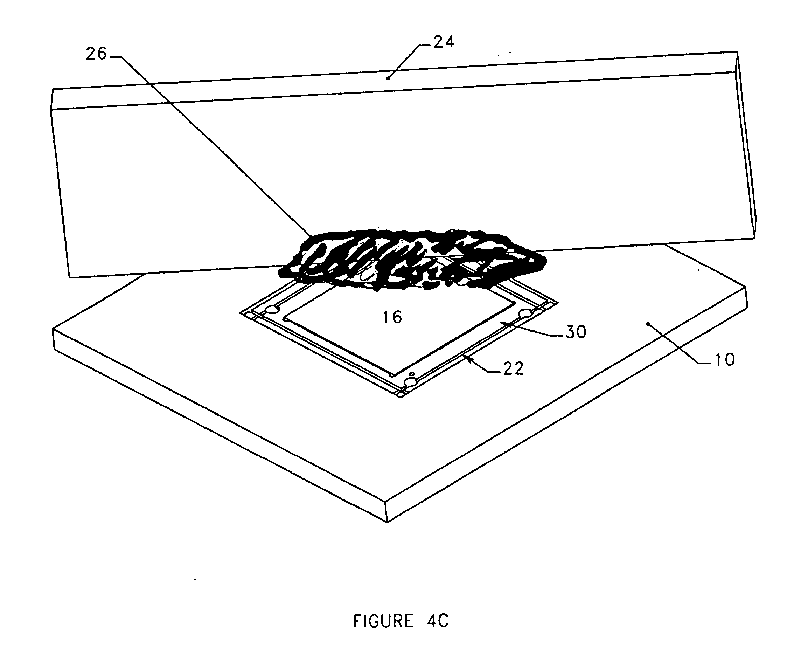

In one example, a sheet 10 of the elastomeric matrix material was punched or cut to a generally "+" shape as shown in FIG. 2A. The stress release slots 30 shown in Fig. 2B allow the square central section to expand isotropically, even though the ends of the cut sheet's four arms will be constrained and thus only able to expand uniaxially. The ends of the cut sheet's four arms 31-34 were then attached by tape to the stretching mechanism 40 shown in FIG. 3. The mechanism has opposed, relatively movable portions. The four rods 41-44 of the stretching mechanism were then rotated in the direction indicated by arrow B such that they stretched the cut sheet of elastomeric material by about 5%. Locking mechanisms 46 hold the rods in place to maintain the material sheet in tension. The effect of the stretching is visibly obvious: the previously flat glossy bottom surface becomes visibly rough, with a matte appearance. With the material in the stretched state, a fiberglass frame 50, shown in FIG. 4, was then glued to the material using Loctite's Permatix Blue RTV Silicone Gasket Maker, Part No. 6B. After a one-day cure, the excess material outside the frame was cut away, leaving the frame and material bonded together with the material in tension. Measuring the amount of stretch (i.e.; the area of the sheet) and the thickness of the sheet before and after stretching showed an apparent 6-7% increase in volume of the sheet. Since the actual volume could not change significantly, this apparent change comes from the topology (increased roughness) created when the elastomer pulls inwards from the surfaces, but the height of the conductive columns remains essentially unchanged. This creates the interstitial volume that is one desired end result of the invention.

Another method of making the interconnection component of the invention described herein addresses many issues described above. It also makes possible the addition of features to the anisotropically conductive elastomeric material that could not be readily done by other manufacturing methods. This embodiment integrates the material sheet formation process with the connector assembly process.

With this method, the connector is made by direct casting of the conductive elastomer onto a suitably-shaped frame, using a casting plate. Figure 4A shows casting plate 10 for use in the embodiment. Plate 10 defines cavity 14 and central pedestal 16. Openings 18 and 20 pass through to the other face (not shown) of casting plate 10. Alignment frame 30 is placed in cavity 14 as shown in Figure 4B. Alignment frame 30 carries openings 22 that are shown in more detail below. The top of pedestal 16 and alignment frame 30 is below the surface of casting plate 10. A sufficient amount of uncured elastomer and blended conductive particles that together comprise uncured material mixture 26, Fig. 4C, is poured onto the casting plate 10 and spread with squeegee or doctor blade 24 to create a film with a thickness defined by the difference in height between pedestal 16 and frame 30, and the upper surface of casting plate 10. Some of the material flows into openings 22 in frame 30, to lock the film to the frame, and thus register the film to the frame. Before the polymer cures, the entire assembly is placed in a magnet and oven to both align the particles and cure the polymer. After the material has cured, the assembled part comprising frame 30 with cured material spanning the central opening in the frame, is then ejected from the assembly using ejection holes 18.

The elastomer is cured at a temperature well above room temperature. As the elastomer cools to room temperature, it will shrink in volume due to its thermal coefficient of expansion. The sheet, however, is confined at its edges by the alignment frame 30. The frame has a lower coefficient of thermal expansion than the elastomer. The elastomer will bond to the frame and retention features in the frame as it cures. When the assembly cools, the elastomer shrinks faster than the frame, thus leaving the material in tension. The sheet contains many vertically rigid columns. The tension causes the interstitial elastomer to substantially contract vertically as it is pulled laterally, due to its relatively high Poisson's ratio, v. This will result in a close to optimum positioning of the columns of conductive particles. The sheet is typically under a sufficient tension so that it acts somewhat like a drum head, in that when it is struck with a finger it gives of a drum-like sound. The tension is preferably sufficient such that the sheet remains in tension over the operating temperature range of the device.

Frame 30 has tooling features (openings 31) that allow frame 30 to be precisely aligned to mold 10 and its associated pedestal 16. Openings 20 in cavity 14 are examples of such tooling features in the casting plate. Registration pins (not shown) passing through openings 31 and 20 accomplish the alignment. Pedestal 16 defines the surface that controllably locates the inner face of the mixture during the casting process. This enables features to be molded into the material which are accurately located to the connector frame. Several applications of this enabling concept are described below.

The figures indicate a single connector manufacturing system for illustrative purposes. In production, multiple connectors will be built simultaneously in a tool, providing a low cost, highly efficient manufacturing process.

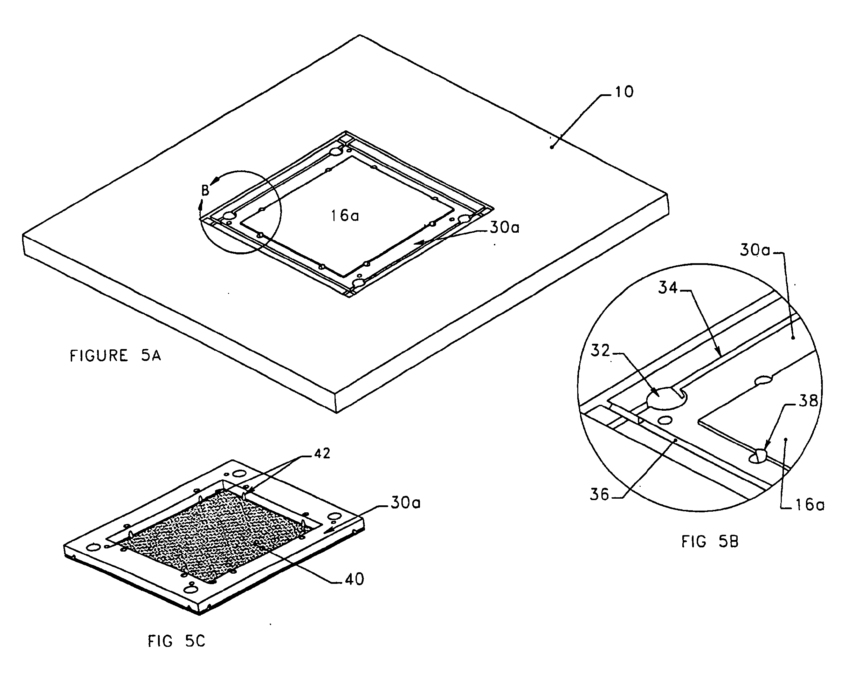

Additional features can be incorporated into the method of making the interconnection component of the invention to better address the functionality of the connector. For example, it is possible to introduce elastomeric device package centering bosses 42 (Fig. 5) into alignment frame 30a during the casting process. This is accomplished by creating voids 38 in alignment frame 30a and pedestal 16a, as indicated in Figure 5. As the elastomer is squeegeed into the plate it will fill these voids, creating cast alignment bosses 42 in the cured sheet 40. This can be designed to optimally accommodate the full mechanical tolerance range of the device. It is also possible to mold or connect springs to the frame structure that will center the device in the connector frame. These centering springs could be accomplished with molded fingers around the inside perimeter of the frame, essentially where bosses 42 would be. These fingers would bias the device inserted into the frame to properly locate the frame/sheet and component.

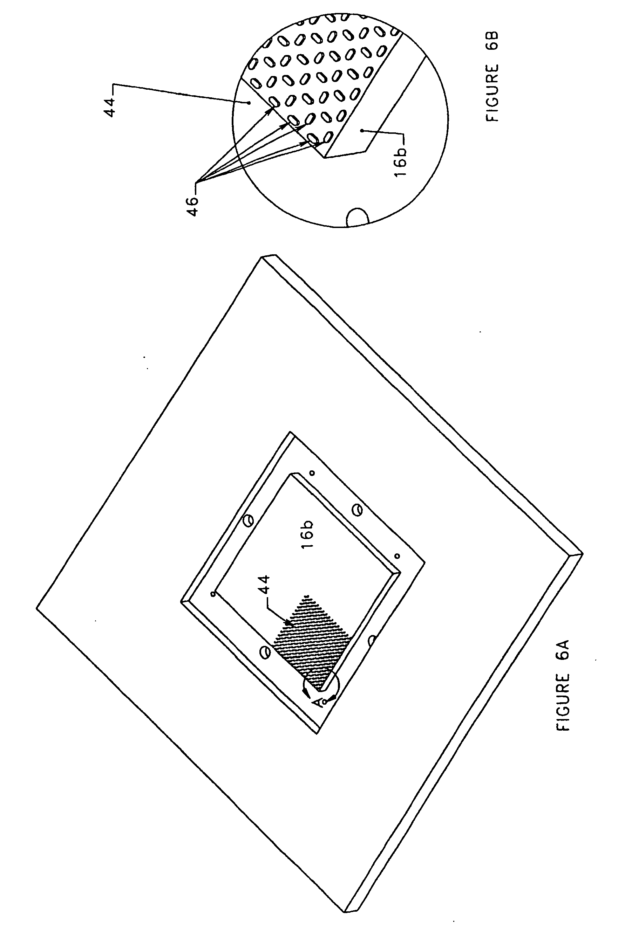

The surface of the pedestal in the alignment plate is replicated by the surface of the elastomer during the casting process. Features which will enhance the performance of the elastomer can be formed on the pedestal, and these will be replicated in the surface of the elastomer. One example of such a feature is shown in Figure 6, where a series 44 of spaced protrusions 46 have been placed on pedestal 16b on a grid which matches the interstitial spaces of the pad array of the device being connected with the material. This will result in an array of dimples in the elastomer, which will both allow for expansion volume of the elastomer, and potentially reduce the opportunity for electrical shorts between adjacent contacts. Protrusions 46 can be applied to pedestal 16b by machining methods, or by the application of a photo definable medium such as solder mask.

The central pedestal of the casting plate can be coated with a mold release that is solid at room temperature, but a liquid at oven temperature. This will melt before the material is cured, creating a liquid film between the material and the pedestal. This allows the conductive columns magnetically forming from the particles in the material to protrude downwards into the liquid film (as well as upwards). The result is that the columns protrude slightly from the surface of the cured sheet. Also, since the bottom particles of the column are in a liquid film, the lateral mobility of the columns is increased, thus enhancing their ability to uniformly distribute by mutual repulsion, thinning out high density anomalies and back-filling into any sparse areas.

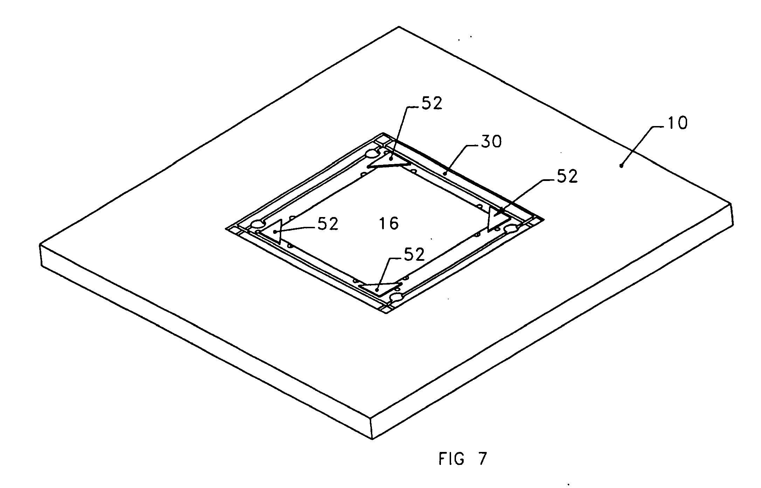

It is also possible to incorporate spacer structures into the connector frame, for example as rigid corner spacers 52, Figure 7. Spacers 52 sit on the frame, between the sheet and the frame. Accordingly, spacers 52 will limit the compression of the elastomer to a fixed compressed thickness. Also, inertial forces caused by shock and vibration of the heat sink and device will be transmitted directly from the device to the substrate (frame), thus isolating the elastomer and its electrical interconnections.

Other methods for accomplishing ACE under tension attached to a structure are also contemplated herein. For example, the material could be cast directly onto a printed circuit board and then cured as described, which eliminates the need for a separate frame to carry the material. Alternatively, the material could be cast on a carrier sheet as in the prior art, and then a frame or board could be bonded to the cured material before it is lifted from the carrier sheet (and thus while it is still in tension). Then, when the material is cut and the frame or board is lifted from the material carrier, the material will be in tension on the structure.

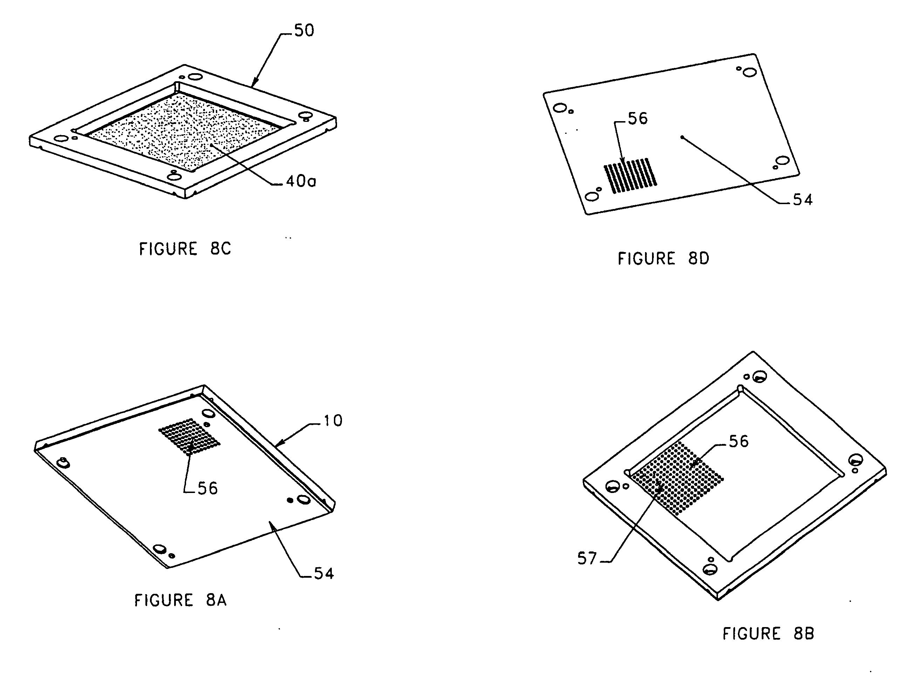

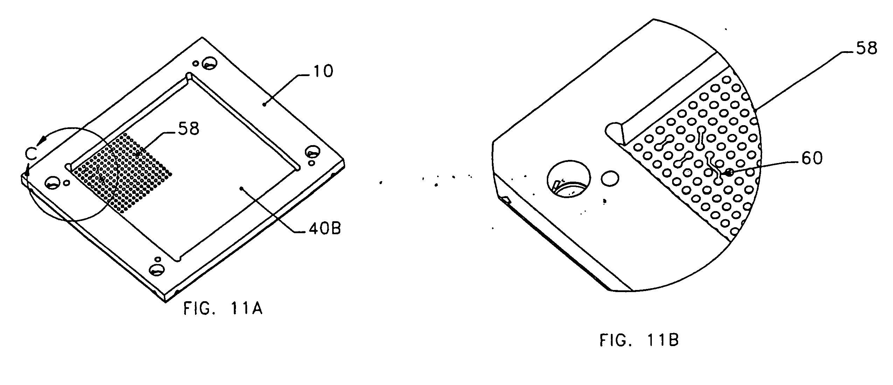

In another preferred embodiment of making the interconnection component of the invention, a flex circuit 54 can be placed in the system as shown in Figure 8. Flex circuit 54 can be mounted on the device side, as shown in the figure, or on the board side of the elastomer. Flex circuit 54 has pads 56 on both sides, interconnected by metalized vias. Pads 56 could be isolated from each other, or interconnected with circuits 57, which are similar to circuits 60, Figure 11. The latter would be useful in providing a means to modify the device interconnect without going through the expense of rebuilding the device.

The flex circuit interposed in this fashion provides several unique enhancements to the design. It provides a robust wear surface for applications requiring many insertion cycles. When used to interconnect BGA (Ball Grid Array) devices, the flex circuit interposer provides a means (properly shaped and sized pads) to optimally transfer the load from the spherical ball to the elastomer. The opposing pad surfaces of the flex or on the material can be sized and plated so as to optimize the interconnection. For example, the pad facing the BGA side could be solder plated. In another example, the pad facing the device could be smaller than the device pad to better accommodate tolerance mismatch issues between the device and board. The pads on the device side of the flex circuit interposer could have asperities formed on them, such as silvered nickel particles or plated diamond shards. These would bite through any oxides or debris on the device pad, enhancing the quality of electrical interconnection.

In another preferred embodiment of making the interconnection component of the invention, either surface of the elastomer could be directly plated with the same interface pad structures described above in conjunction with Figure 8. See Fig. 11, wherein pads 58 have been directly plated on material 40b, and may included pad interconnecting circuits 60. Contacts 58 provide many of the same functions provided by the flex circuit described above. These pads provide a robust wear surface for applications requiring many insertion cycles.

An embodiment of the present invention combines the elastomeric conductive material with a unique flexible circuit resulting in a circuit with low inductance and one that doesn't damage the apex area of the solder ball on a BGA package. This inventive concept is unique because it has significantly less inductance and still maintains the integrity of the face of the solder ball.

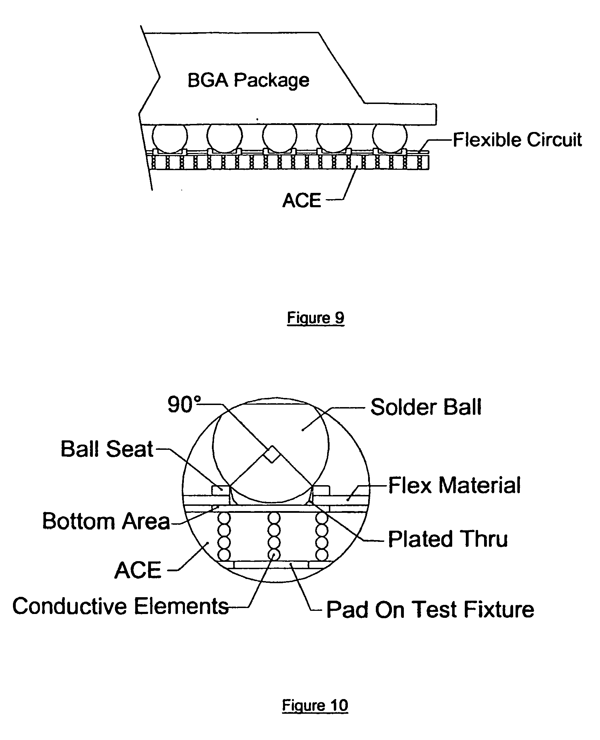

Figure 9 presents a section view through the centerline of one of the rows of solder balls. This drawing demonstrates an embodiment of the inventive design. The design combines a unique flex circuit with the material to create an interconnect system with low inductance that protects the apex of the BGA, or the end or top of the land or pin.

Figure 10 presents an expanded view of a single solder ball interconnected to a board using the unique flex/material interconnect of the invention. The flex circuit houses planted through holes that have a different top and bottom configuration. The top side (the side facing the solder ball) has a finished hole size that allows the ball to "seat" in the hole. The finished hole is preferably sized such that the triangle formed between the ball center and the tangent points to the plated through hole form an angle of about 90 degree. The bottom side of the hole is a solid area providing maximum contact with the material. The flex circuit protects the ball as well as providing wipe during interconnection. It also serves as a wear member allowing many reuse cycles. It also provides limited compensation for lack of device flatness and tolerance variation on the ball diameter. This compensation is, in general, insufficient for the broad range of BGA devices available. Most of the dynamic range is provided by the material which adds several mils of dynamic range to the interconnect.

The flex circuit is made from a base material consisting of a polymer flex circuit with copper laminated on one side. A laser is used to drill holes through the polymer from the non-copper side. The laser is tuned to penetrate the flex material (electrically insulating polyimide material), but not the copper. Conventional plate, print and etch technology is used to form the pads and interconnect the top and bottom layers. The combination of laser drilled and plated holes results in the desired finished hole size.

Figures 9 and 10 reference one such configuration. Alternate forms are as follows:
1. Instead of electrically insulating polyimide material as the carrier in the flexible circuit, the interconnection component could utilize a more compliant material such as silicone. This variation would allow the gold plated pads a degree of motion that would assist in the alignment of the solder ball.
2. The pattern that contacts the solder ball has been shown as circular. Other shapes are contemplated, such as diamond or square shaped to facilitate different interconnecting geometries, or to provide a smaller contact patch. The use of a laser allows the creation of holes of any shape.
3. What is shown herein is the flex and material as two distinct parts. However, the material could be cast directly on the flexible circuit itself.

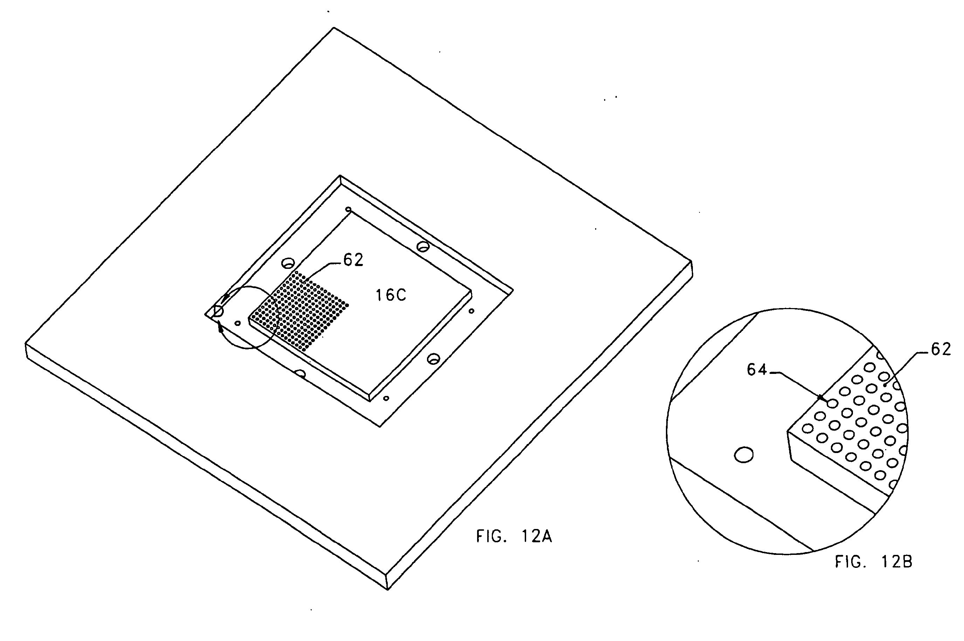

Pedestal 16c, Fig. 12, could incorporate an array 62 of zones 64 containing high magnetic permeability material, on the same grid as the device contacts. Zones 64 focus the magnetic field in the material while it is being cured, so that the conductive particle column density will be highest in the vicinity of an interconnect, and lowest in the space between contacts. This simultaneously increases the contact conductivity and the insulation resistance between neighboring contacts.

Two additional methods and apparatus for stretching of the material, a fixed stretch frame and a variable stretch frame are described herein. Other methods and apparatus, based on this disclosure, will become obvious to those skilled in the art.

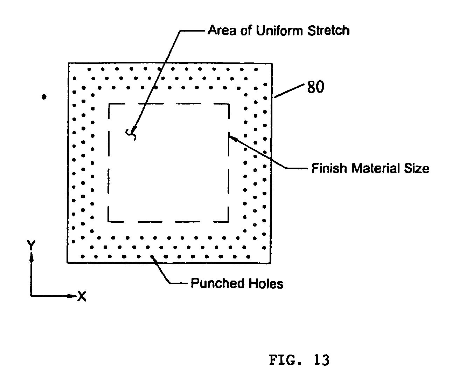

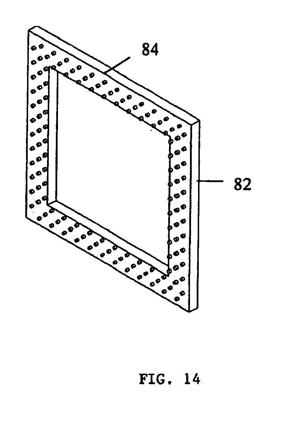

Figure 13 shows a coupon 80 ( prepared sheet) of the material prior to fitting it on the fixed stretch frame. The coupon has an array of punched holes formed at the periphery in a defined pattern. Figure 14 shows a mounting frame 82 with an array of pins 84 onto which the coupon 80 is mounted. The relationship between the holes in the coupon 80 and the pins 84 on the frame 82 is such that the coupon is placed in generally uniform, radial tension when it is mounted on the frame. The relationship between the pins and holes is established to develop the desired tension in the coupon. The useable area of the coupon, which is under tension, is indicated by the dashed line of Figure 13.

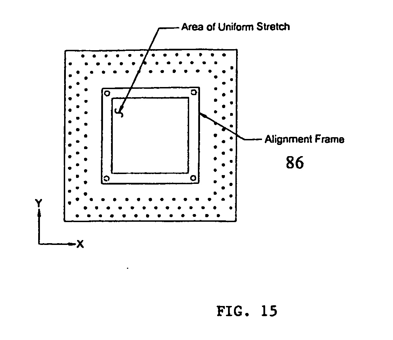

Once the coupon has been stretched, a rigid frame 86, Figure 15, is bonded by mechanical or adhesive means to the active area of the coupon. It should be noted that the size of the stretch frame and coupon can be so as to accommodate one or several rigid frames. Once the rigid frame(s) are bonded to the coupon, the rigid frame and associated material can be removed from the coupon, with the tension in the material being maintained by the rigid frame. Figure 15 shows a single rigid frame 86 bonded to the stretched coupon 80 prior to its removal. In this example, the rigid frame serves as the alignment vehicle between the device and board.

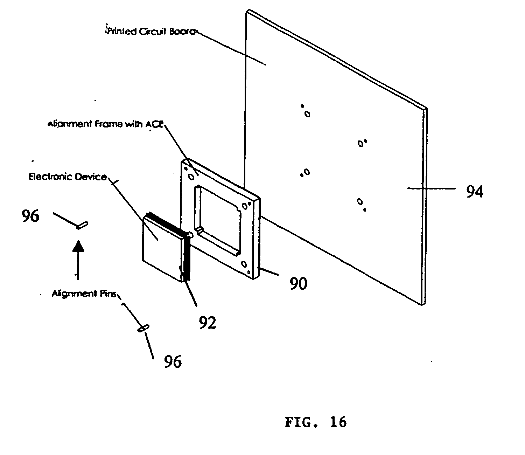

As shown in Figure 16, assembly 90 comprising the alignment frame 86 with the material attached is used to electrically connect the electronic device 92 to the printed circuit board 94. Alignment of the electronic device is accomplished by the internal cutout of the alignment frame, or other features (not shown), and transferred to the printed circuit board via the alignment pins 96.

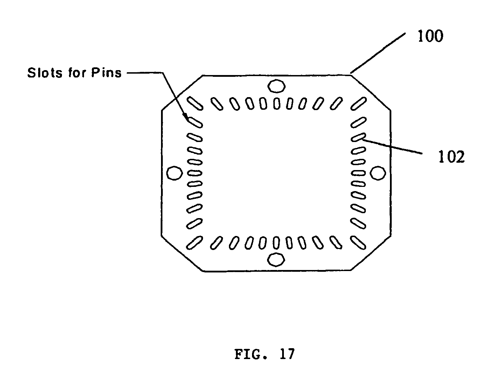

The above describes an apparatus that provides a fixed, uniform stretch to the material. The following describes an apparatus used to apply a variable level of uniform stretch to the material. Figure 17 is a top view of variable stretch frame fixture 100. The slots 102 act as guides that let actuator pins move radially. Slots 102 are aligned along radii from the center of fixture 100. This approach gives continuous generally uniform radial stretch to a material coupon.

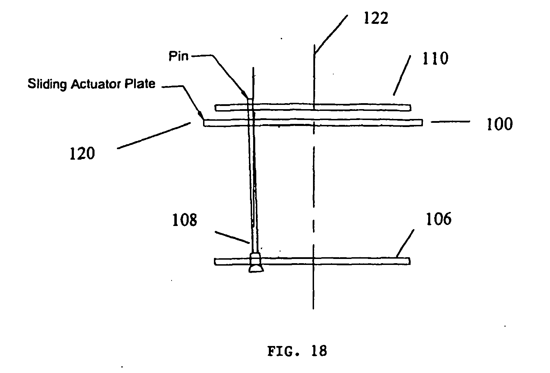

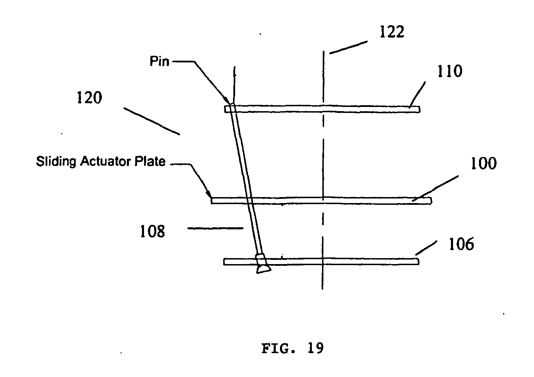

Figures 18 and 19 are side views of assembly 120 that uses fixture 100 to stretch a material coupon. The figures show assembly 120 in the initial and material-stretching positions, respectively. The space between the top 110 and bottom 106 plates is fixed by spacers (not shown). The sliding actuator plate 100 is free to move up and down between the top and bottom plate, but is confined by a means (not shown) to stay parallel to the top plate 110. An array of pins such as pin 108 are pivotally mounted to the bottom plate 106 so that each pin 108 can pivot relative to the assembly central axis 122, but are radially fixed at the bottom plate 106. These pins 108 pass through slots 102 in actuator plate 100. Because pins 108 are slightly canted out, as actuator plate 100 is lowered from its top position (Figure 18) to its bottom position (Figure 19), pins 108 are driven by actuator plate 100 from the inner ends of the slots 102 in the top plate, toward the outer ends of the slots 102. A coupon (not shown) mounted on the pins (e.g. on plate 100 or plate 110) would be radially stretched to a degree based on the final position of the actuator plate. A direct relationship between the degree of stretch and the position of the sliding actuator plate can be determined, allowing a defined amount of stretch for a defined vertical plate motion.

As with the fixed stretch frame, a material coupon with properly positioned holes is mounted to the pins. This is done with the actuator plate at the top position, allowing the coupon to be attached with little or no tension. The actuator plate is then lowered, uniformly radially stretching the coupon. A rigid frame is then bonded to the sheet, as described above, to maintain the material coupon in tension.

Other embodiments will occur to those skilled in the art and are within the following claims. For example, the tension in the material does not have to be radial; it could be in any one or two dimensions of the material, to achieve a desired result.

## Claims

1. An interconnection component with conductive elastomeric sheet material, comprising
a frame (30) defining an opening and
an anisotropic conductive elastomer material (10) coupled to the frame (30),
**characterized in that** the material (10) spans the frame opening under tension, and the material (10) defines a series of spaced conductive columns (14) through its thickness.

2. The interconnection component of claim 1, wherein the material (10) is integrally coupled to the frame (30).

3. The interconnection component of claim 2, wherein the integral coupling is enhanced with one or more openings (22) in the frame (30), in which the material (10) is held.

4. The interconnection component of claim 3, wherein the frame (30) is annular, and the openings (22) are along at least two opposed sides of the frame (30).

5. The interconnection component of claim 4, wherein the frame (30) is generally rectangular and the openings (22) are along all four sides of the frame.

6. The interconnection component of claim 1, further comprising one or more protrusions (46) in the material (10), and in contact with the frame (30), to help to maintain registration between the interconnection component and a device.

7. The interconnection component of claim 1, wherein the conductive columns (14) in the material (10) protrude from at least one surface of the material (10).

8. The interconnection component of claim 1, wherein the material (10) defines one or more depressions (24) proximate at least some of the conductive columns.

9. The interconnection component of claim 1, further comprising one or more spacers (52) between one or more portions of the frame (30) and the material (10).

10. The interconnection component of claim 1, further comprising a flexible circuit interconnect (54) in electrical contact with the material (10), to enhance interconnection of a device to the material (10).

11. The interconnection component of claim 10, wherein the flexible circuit interconnect (54) has pads (56) on at least one side.

12. The interconnection component of claim 11, wherein at least some of the pads (56) define a conductive opening having a diameter smaller than that of a connecting structure, to seat the connecting structure in the opening.

13. The interconnection component of claim 12, wherein the connecting structure comprises a ball of a ball grid array.

14. The interconnection component of claim 1, further comprising a series of electrical interconnects (57) on the material surface and in electrical contact with the conductive columns (14).

15. The interconnection component of claim 1, wherein the frame (30) has a lowers coefficient of thermal expansion than the material (10), so that the material is held in tension.

16. The interconnection component of claim 6, wherein the protrusion is created with a material that is liquid at the material casting temperature.

17. The interconnection component of claim 1, wherein the material (10) is in sufficient tension such that it produces an audible sound when struck by a finger.

18. The interconnection component of claim 1, wherein the material (10) remains in tension over the entire operating range of the component.

## Patentansprüche

1. Steckerkomponente mit leitfähigem elastomerem Plattenmaterial, umfassend:
einen Rahmen (30), der eine Öffnung definiert, und ein anisotropes leitfähiges Elastomermaterial (10), das an den Rahmen (30) gekoppelt ist,
**dadurch gekennzeichnet, dass** das Material (10) die Rahmenöffnung unter Zugspannung überspannt und das Material (10) eine Serie von beabstandeten leitfähigen Säulen (14) durch seine Dicke definiert.

2. Steckerkomponente nach Anspruch 1, wobei das Material (10) integral an den Rahmen (30) gekoppelt ist.

3. Steckerkomponente nach Anspruch 2, wobei die integrale Kopplung mit einer oder mehreren Öffnungen (22) in dem Rahmen (30), in dem das Material (10) gehalten wird, verstärkt wird.

4. Steckerkomponente nach Anspruch 3, wobei der Rahmen (30) ringförmig ist und die Öffnungen (22) sich entlang mindestens zwei gegenüberliegenden Seiten des Rahmens (30) befinden.

5. Steckerkomponente nach Anspruch 4, wobei der Rahmen (30) im Allgemeinen rechteckig ist und sich die Öffnungen (22) entlang allen vier Seiten des Rahmens befinden.

6. Steckerkomponente nach Anspruch 1, weiterhin umfassend einen oder mehrere Vorsprünge (46) in dem Material (10) und in Kontakt mit dem Rahmen (30), um das Aufrechterhalten einer Registrierung zwischen der Steckerkomponente und einer Einrichtung zu unterstützen.

7. Steckerkomponente nach Anspruch 1, wobei die leitfähigen Säulen (14) in dem Material (10) von mindestens einer Oberfläche des Materials (10) vorstehen.

8. Steckerkomponente nach Anspruch 1, wobei das Material (10) eine oder mehrere Vertiefungen (24) bei mindestens einigen der leitenden Säulen definiert.

9. Steckerkomponente nach Anspruch 1, weiterhin umfassend einen oder mehrere Abstandshalter (52) zwischen einem oder mehreren Abschnitten des Rahmens (30) und dem Material (10).

10. Steckerkomponente nach Anspruch 1, weiterhin umfassend einen flexiblen Schaltungsstecker (54) in elektrischem Kontakt mit dem Material (10), um das Stecken einer Einrichtung an das Material (10) zu verbessern.

11. Steckerkomponente nach Anspruch 10, wobei der flexible Schaltungsstecker (54) Pads (56) auf mindestens einer Seite aufweist.

12. Steckerkomponente nach anspruch 11, wobei mindestens einige der Pads (56) eine leitfähige Öffnung mit einem Durchmesser definieren, der kleiner ist als der einer verbindenden Struktur, um die verbindende Struktur in die Öffnung einzusetzen.

13. Steckerkomponente nach Anspruch 12, wobei die verbindende Struktur eine Kugel eines Ball-Grid-Arrays umfasst.

14. Steckerkomponente nach Anspruch 1, weiterhin umfassend eine Reihe von elektrischen Zwischenverbindungen (57) auf der Materialoberfläche und in elektrischem Kontakt mit den leitenden Säulen (14).

15. Steckerkomponente nach Anspruch 1, wobei der Rahmen (30) einen niedrigeren Wärmeausdehnungskoeffizienten als das Material (10) aufweist, so dass das Material unter Zugspannung gehalten wird.

16. Steckerkomponente nach Anspruch 6, wobei der Vorsprung mit einem Material hergestellt wird, das bei der Materialgießtemperatur flüssig ist.

17. Steckerkomponente nach Anspruch 1, wobei das Material (10) unter ausreichender Zugspannung steht, so dass es bei Berührung mit einem Finger einen hörbaren Ton erzeugt.

18. Steckerkomponente nach Anspruch 1, wobei das Material (10) über den ganzen Arbeitsbereich der Komponente hinweg unter Zugspannung bleibt.

## Revendications

1. Composant d'interconnexion comportant un matériau élastomère conducteur sous forme de feuille, comprenant :
un cadre (30) définissant une ouverture et
un matériau élastomère conducteur anisotrope (10) couplé au cadre (30),
**caractérisé en ce que** le matériau (10) couvre l'ouverture du cadre sous tension, et le matériau (10) définit une série de colonnes conductrices espacées (14) à travers son épaisseur.

2. Composant d'interconnexion selon la revendication 1, dans lequel le matériau (10) est intégralement couplé au cadre (30).

3. Composant d'interconnexion selon la revendication 2, dans lequel le couplage intégral est renforcé avec une ou plusieurs ouvertures (22) dans le cadre (30), dans lesquelles le matériau (10) est maintenu.

4. Composant d'interconnexion selon la revendication 3, dans lequel le cadre (30) est annulaire, et les ouvertures (22) sont situées le long d'au moins deux côtés opposés du cadre (30).

5. Composant d'interconnexion selon la revendication 4, dans lequel le cadre (30) est généralement rectangulaire et les ouvertures (22) sont situées le long des quatre côtés du cadre.

6. Composant d'interconnexion selon la revendication 1, comprenant en outre une ou plusieurs saillies (46) dans le matériau (10), et en contact avec le cadre (30), pour aider à maintenir le positionnement relatif du composant d'interconnexion par rapport à un dispositif.

7. Composant d'interconnexion selon la revendication 1, dans lequel les colonnes conductrices (14) dans le matériau (10) dépassent d'au moins une surface du matériau (10).

8. Composant d'interconnexion selon la revendication 1, dans lequel le matériau (10) définit une ou plusieurs dépressions (24) proximales à au moins certaines des colonnes conductrices.

9. Composant d'interconnexion selon la revendication 1, comprenant en outre un ou plusieurs séparateurs (52) entre une ou plusieurs parties du cadre (30) et du matériau (10).

10. Composant d'interconnexion selon la revendication 1, comprenant en outre une interconnexion de circuit flexible (54) en contact électrique avec le matériau (10), pour renforcer l'interconnexion d'un dispositif au matériau (10).

11. Composant d'interconnexion selon la revendication 10, dans lequel l'interconnexion de circuit flexible (54) comporte des plaquettes (56) sur au moins un côté.

12. Composant d'interconnexion selon la revendication 11, dans lequel au moins certaines des plaquettes (56) définissent une ouverture conductrice ayant un diamètre inférieur à celui d'une structure connectrice, pour caler la structure connectrice dans l'ouverture.

13. Composant d'interconnexion selon la revendication 12, dans lequel la structure connectrice comporte une bille d'un boîtier à billes.

14. Composant d'interconnexion selon la revendication 1, comportant en outre une série d'interconnexions électriques (57) sur la surface du matériau et en contact électrique avec les colonnes conductrices (14).

15. Composant d'interconnexion selon la revendication 1, dans lequel le cadre (30) a un coefficient de dilatation thermique inférieur à celui du matériau (10), de sorte que le matériau soit maintenu sous tension.

16. Composant d'interconnexion selon la revendication 6, dans lequel la saillie est formée d'un matériau qui est liquide à la température de coulée du matériau.

17. Composant d'interconnexion selon la revendication 1, dans lequel le matériau (10) est sous une tension suffisante pour produire un son audible quand on le frappe avec un doigt.

18. Composant d'interconnexion selon la revendication 1, dans lequel le matériau (10) reste sous tension dans toute la plage de fonctionnement du composant.
